# EUROPEAN PATENT APPLICATION

(11) **EP 2 090 911 A1**
(43) Date of publication of application: **19.08.2009**
(21) Application number: 09152712.7
(22) Date of filing: 12.02.2009
(51) Int. Cl.: G02B 6/43, G02B 6/122, G02B 6/13, G02B 6/136, G02B 6/42, H05K 1/02, H05K 3/46, H05K 1/14

(54) **Manufacturing method of opto-electric hybrid board and opto-electric hybrid board obtained thereby**

(30) Priority: 14.02.2008 JP 2008033388
(71) Applicant: Nitto Denko Corporation, Ibaraki-shi, Osaka 567-8680 (JP)
(72) Inventor: Hodono, Masayuki, Osaka Ibaraki 567-8680 (JP)
(74) Representative: Skuhra, Udo

(57) **Abstract**

A method of manufacturing an opto-electric hybrid board capable of optically coupling light-emitting (60) and light-receiving elements (61) mounted on an electrical wiring board (A) and an optical waveguide provided in an optical wiring board (B) to each other easily with high accuracy. An opto-electric hybrid board obtained thereby. Guide pins (70) have end portions fitted in alignment openings (32) of an electrical wiring board and end portions fitted in alignment openings (42) of an optical wiring board to accomplish alignment therebetween. The electrical wiring board is configured such that a conductor layer having pads for mounting light-emitting and light-receiving elements thereon and interconnect lines is formed on a metal substrate, and the alignment openings are formed in the metal substrate (20). The optical wiring board is configured such that an optical waveguide is formed on a metal substrate (40), and optical coupling openings (43) for the optical waveguide and the alignment openings (42) are formed in the metal substrate.

## Description

### BACKGRROUND OF THE INVENTION

### 1. Field of the Invention

The present invention relates to a method of manufacturing an opto-electric hybrid board which has found wide use in a variety of electric and electronic technologies using optics such as optical communications, optical information processing and the like, and to an opto-electric hybrid board obtained thereby.

### 2. Description of the Related Art

In recent years, rapid advances in technologies regarding optical communications, optical information processing and the like have led to increasing demand for an opto-electric hybrid board in which optical interconnect lines (an optical waveguide) and electrical interconnect lines (a metallization pattern) are combined on the same board.

An example of the above-mentioned opto-electric hybrid board used widely includes an opto-electric hybrid board in which a board 2 formed with a metallization pattern 1 and an optical waveguide 6 including a core layer 5 held between cladding layers 3 and 4 are integrally laminated to each other with an adhesive layer 7, as shown in Fig. 20 (see, for example, Japanese Patent Application Laid-Open No. 2004-20767).

This will be described in further detail. A light-emitting element 8 for converting an electric signal into an optical signal and a light-receiving element 9 for converting an optical signal into an electric signal are connected to each other on the above-mentioned metallization pattern 1. A light beam emitted from the light-emitting element 8 is transmitted via through holes 10 formed through the above-mentioned board 2 and via the core layer 5 of the optical waveguide 6 to the light-receiving element 9. The optical path of this light beam is indicated by a dashed arrow L'. The above-mentioned core layer 5 is formed with optical path conversion mirrors 11 each having a surface inclined at 45 degrees to change the optical path by 90 degrees.

In such an opto-electric hybrid board, it is very important to locate the light-emitting and light-receiving points of the light-emitting and light-receiving elements 8 and 9 connected to the metallization pattern 1 and the light-receiving and light-emitting points of the optical waveguide 6 on the same axis in the light of light transmission efficiency. A high degree of accuracy is accordingly required for alignment during the process of laminating the optical waveguide 6 to the board 2. To this end, alignment marks are previously printed on the board 2 and the optical waveguide 6, and are then recognized by image processing so that the board 2 and the optical waveguide 6 are bonded to each other in position when the board 2 and the optical waveguide 6 are laminated to each other.

However, a series of positioning processes involving image processing as described above not only require very cumbersome and complicated labor but also present a problem such that the optical waveguide and the board are liable to be deformed by heat and tension during processing and during lamination and bonding, thereby finding difficulties in providing good accuracy.

In view of the foregoing, it is an object of the present invention to provide a method of manufacturing an opto-electric hybrid board which is capable of optically coupling light-emitting and light-receiving elements mounted on an electrical wiring board and an optical waveguide provided in an optical wiring board to each other easily with high accuracy, and an opto-electric hybrid board obtained thereby.

### DISCLOSURE OF THE INVENTION

To accomplish the above-mentioned obj ect, a first aspect of the present invention is intended for a method of manufacturing an opto-electric hybrid board, which comprises: simultaneously transferring a conductor and opening pattern onto a metal substrate a for electrical wiring by photolithography, the conductor and opening pattern being indicative of the arrangement of pads for mounting light-emitting and light-receiving elements thereon, interconnect lines and alignment openings, and then forming a conductor layer having the pads for mounting the light-emitting and light-receiving elements thereon and the interconnect lines, and the alignment openings, based on the conductor and opening pattern, to thereby produce an electrical wiring board A; simultaneously transferring an opening pattern onto a metal substrate b for optical wiring by photolithography, the opening pattern being indicative of the arrangement of optical coupling openings and alignment openings, then forming the optical coupling openings and the alignment openings, based on the opening pattern, and then forming an optical waveguide by using said alignment openings as alignment marks, to thereby produce an optical wiring board B; and preparing guide pins for alignment, fitting first ends of the respective guide pins into the alignment openings of said electrical wiring board A and fitting second ends of the respective guide pins into the alignment openings of said optical wiring board B to perform alignment between said electrical wiring board A and the optical wiring board B, and fixing fitted portions between said guide pins and the alignment openings in this state.

A second aspect of the present invention is intended for a method of manufacturing an opto-electric hybrid board, which comprises: preparing a strip-shaped metal substrate having a first longitudinal end for use as a metal substrate a for electrical wiring and a second longitudinal end for use as a metal substrate b for optical wiring, transferring an opening pattern of alignment openings onto a region of said strip-shaped metal substrate for use as the metal substrate a and a region thereof for use as the metal substrate b by photolithography, the alignment openings being used for alignment with said two regions opposed to each other by folding back, and forming the alignment openings based on the opening pattern; transferring a conductor pattern onto the region of said strip-shaped metal substrate for use as the metal substrate a by photolithography by using said alignment openings as alignment marks, the conductor pattern being indicative of pads for mounting light-emitting and light-receiving elements thereon and interconnect lines, and then forming a conductor layer having the pads for mounting the light-emitting and light-receiving elements thereon and the interconnect lines, based on the conductor pattern, to thereby produce an electrical wiring board portion A'; forming an optical waveguide in the region of said strip-shaped metal substrate for use as the metal substrate b by using said alignment openings as alignment marks, to thereby produce an optical wiring board portion B'; preparing guide pins for alignment, fitting first ends of the respective guide pins into the alignment openings of said electrical wiring board portion A' and fitting second ends of the respective guide pins into the alignment openings of said optical wiring board portion B', with said electrical wiring board portion A' and the optical wiring board portion B' opposed to each other by folding back, to perform alignment between said electrical wiring board portion A' and the optical wiring board portion B'; and fixing fitted portions between said guide pins and the alignment openings in this state.

A third aspect of the present invention is intended for an opto-electric hybrid board obtained by the manufacturing method according to the first aspect, which comprises: an electrical wiring board (A), an optical wiring board (B), and guide pins for alignment, said guide pins having respective first ends fitted in alignment openings of said electrical wiring board (A), and respective second ends fitted in alignment openings of said optical wiring board (B) to accomplish alignment between said electrical wiring board (A) and said optical wiring board (B), wherein fitted portions between the alignment openings and the guide pins for alignment are fixed in this state, said electrical wiring board (A) being configured such that a conductor layer having pads for mounting light-emitting and light-receiving elements thereon and interconnect lines is formed on a metal substrate a, and the alignment openings are formed in the metal substrate a, said optical wiring board (B) being configured such that an optical waveguide is formed on a metal substrate b, and optical coupling openings for the optical waveguide and the alignment openings are formed in the metal substrate b.

A fourth aspect of the present invention is intended for an opto-electric hybrid board obtained by the manufacturing method according to the second aspect, which comprises: a strip-shaped metal substrate having a first longitudinal end provided with an electrical wiring board portion (A') and a second longitudinal end provided with an optical wiring board portion (B'), and guide pins for alignment, said guide pins having respective first ends fitted in alignment openings of said electrical wiring board portion (A') and respective second ends fitted in alignment openings of said optical wiring board portion (B'), with said strip-shaped metal substrate folded back so that said electrical wiring board portion (A') and said optical wiring board portion (B') are opposed to each other, to accomplish alignment between said electrical wiring board portion (A') andsaidoptical wiring board portion (B'), wherein fitted portions between said guide pins and the alignment openings are fixed in this state, said electrical wiring board portion (A') being configured such that a conductor layer having pads for mounting light-emitting and light-receiving elements thereon and interconnect lines, and the alignment openings are formed in a region of the strip-shaped metal substrate for use as a metal substrate a, said optical wiring board portion (B') being configured such that an optical waveguide, optical coupling openings for the optical waveguide, and the alignment openings are formed in a region of the strip-shaped metal substrate for use as a metal substrate b.

The present inventor has diligently made studies of a method of optically coupling light-emitting and light-receiving elements mounted on an electrical wiring board and an optical waveguide provided in an optical wiring board to each other easily with high accuracy. As a result, the present inventor has found that the light-emitting and light-receiving elements and the optical waveguide are optically coupled to each other easily with high accuracy by using a metal substrate for each of the electrical wiring board and the optical wiring board and by the process of forming alignment openings in the electrical wiring board and the optical wiring board by lithography, and then fitting and fixing guide pins in the alignment openings. Thus, the present inventor has attained the present invention.

In the method of manufacturing the opto-electric hybrid board according to the first aspect of the present invention, the alignment openings are formed by photolithography in the electrical wiring board and the optical wiring board as described above, and are fixed coaxially with the single guide pin. This accomplishes the positioning of the electrical wiring board and the optical wiring board easily and accurately to provide optical coupling with high accuracy. Additionally, the above-mentioned electrical wiring board has the advantage of correctly positioning the above-mentioned alignment openings and a conductor pattern of pads, interconnect lines and the like because the alignment openings and the conductor pattern are formed at the same time by using a single photomask. Similarly, the above-mentioned optical wiring board has the advantage of correctly positioning the above-mentioned alignment openings and optical coupling openings because the alignment openings and the optical coupling openings are formed at the same time by using a single photomask. The use of the metal substrate for the electrical wiring board and the optical wiring board offers the advantage of providing high dimensional stability of the boards to allow the stable retention of the arrangement of the above-mentioned correctly positioned members. This eliminates the need for conventional cumbersome and complicated labor to achieve high-accuracy optical coupling, thereby significantly reducing manufacturing costs and operating time.

In the method of manufacturing the opto-electric hybrid board according to the second aspect of the present invention, the strip-shaped metal substrate has the first end provided with the electrical wiring board portion and the second end provided with the optical wiring board portion. The alignment openings are formed in the board portions in a manner similar to that described above, and the strip-shaped metal substrate is folded back. The electrical wiring board portion and the optical wiring board portion in a stacked relation are fixed coaxially with the guide pins. This accomplishes the positioning of the electrical wiring board portion and the optical wiring board portion easily and accurately to provide optical coupling with high accuracy. Additionally, this method has the advantage of correctly positioning the alignment openings and optical coupling openings because the alignment openings in the above-mentioned electrical wiring board portion and the optical wiring board portion and the optical coupling openings in the optical wiring board portion are formed at the same time by using a single photomask. Since the electrical wiring board portion and the optical wiring board portion are constructed by the common metal substrate, the method offers the advantage of providing high dimensional stability of the boards to allow the stable retention of the arrangement of the above-mentioned correctly positioned members. This eliminates the need for conventional cumbersome and complicated labor to achieve high-accuracy optical coupling, thereby significantly reducing manufacturing costs and operating time.

The opto-electric hybrid boards obtained by these manufacturing methods are capable of transmitting light with high efficiency because the optical coupling is achieved, with the electrical wiring board and the optical wiring board to be stacked being positioned with high accuracy.

### Brief Description of Drawings

Fig. 1(a) is a view illustrating a manufacturing step of an electrical wiring board according to a first preferred embodiment of the present invention.
Fig. 1(b) is a sectional view of Fig. 1(a).
Fig. 2 (a) is a view illustrating a manufacturing step of the electrical wiring board according to the above-mentioned preferred embodiment.
Fig. 2(b) is a sectional view of Fig. 2(a).
Fig. 3 is a view illustrating a manufacturing step of the electrical wiring board according to the above-mentioned preferred embodiment.
Fig. 4 (a) is a view illustrating a manufacturing step of the electrical wiring board according to the above-mentioned preferred embodiment.
Fig. 4(b) is a sectional view of Fig. 4(a).
Fig. 5 is a view illustrating a manufacturing step of the electrical wiring board according to the above-mentioned preferred embodiment.
Fig. 6 (a) is a view illustrating a manufacturing step of the electrical wiring board according to the above-mentioned preferred embodiment.
Fig. 6(b) is a sectional view of Fig. 6(a).
Fig. 7 is a view illustrating a manufacturing step of the electrical wiring board according to the above-mentioned preferred embodiment.
Fig. 8 (a) is a view illustrating a manufacturing step of the electrical wiring board according to the above-mentioned preferred embodiment.
Fig. 8(b) is a sectional view of Fig. 8(a).
Fig. 9 (a) is a view illustrating a manufacturing step of the electrical wiring board according to the above-mentioned preferred embodiment.
Fig. 9(b) is a sectional view of Fig. 9(a).
Figs. 10(a) and 10(b) are views illustrating manufacturing steps of the electrical wiring board according to the above-mentioned preferred embodiment.
Figs. 11(a) and 11(b) are views illustrating manufacturing steps of an optical wiring board according to the above-mentioned preferred embodiment.
Fig. 11(c) is a sectional view taken along the lines X-X'-Y'-Y of Fig. 11(b).
Fig. 12 (a) is a view illustrating a manufacturing step of the optical wiring board according to the above-mentioned preferred embodiment.
Fig. 12(b) is a sectional view of Fig. 12(a).
Fig. 13 is a view illustrating a manufacturing step of the optical wiring board according to the above-mentioned preferred embodiment.
Fig. 14 (a) is a view illustrating a manufacturing step of the optical wiring board according to the above-mentioned preferred embodiment.
Fig. 14(b) is a sectional view of Fig. 14(a).
Figs. 15(a), 15(b) and 15(c) are views illustrating manufacturing steps of the optical wiring board according to the above-mentioned preferred embodiment.
Fig. 16 is a view illustrating the step of assembling the electrical wiring board and the optical wiring board according to the above-mentioned preferred embodiment.
Fig. 17(a) is a view illustrating the step of assembling the electrical wiring board and the optical wiring board according to the above-mentioned preferred embodiment.
Fig. 17 (b) is a view illustrating guide pins and a spacer for use in the above-mentioned assembling step.
Fig. 18 is a view illustrating a second preferred embodiment according to the present invention.
Fig. 19 (a) is a view illustrating a strip-shaped metal substrate for use in the above-mentioned second preferred embodiment.
Fig. 19 (b) is a view illustrating a modification of optical coupling openings according to the present invention.

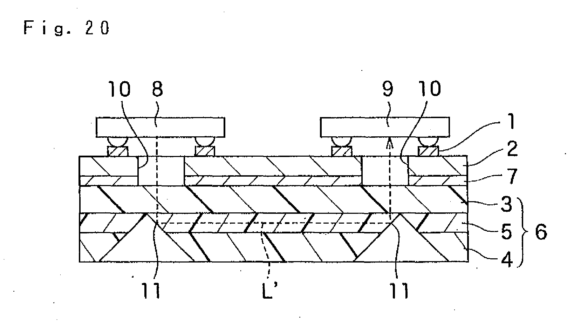

Fig. 20 is a view schematically illustrating a conventional opto-electric hybrid board.

### DETAILED DESCRIPTION

A method of manufacturing an opto-electric hybrid board according to the best mode of the present invention includes three steps: (1) the production of an electrical wiring board; (2) the production of an optical wiring board; and (3) the alignment and fixing of the electrical and optical wiring boards, which will be described in order.

### (1) Production of Electrical Wiring Board

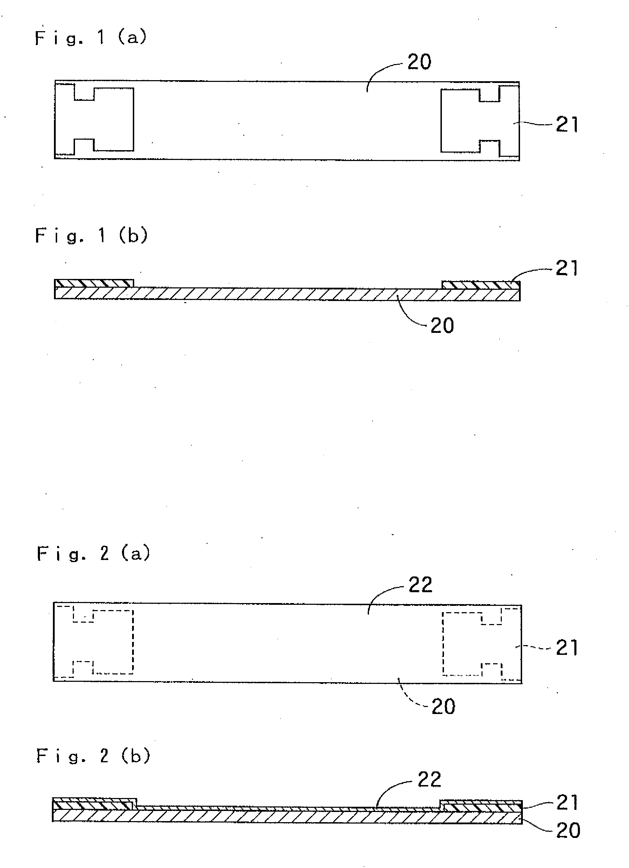

First, an insulation layer 21 is formed in two predetermined regions, i.e. a right-hand region and a left-hand region, of a first surface of a metal substrate 20 having a flat shape, as shown in Fig. 1(a) and Fig. 1(b) which is a sectional view of Fig. 1(a).

Preferably, the material of the above-mentioned metal substrate 20 is stainless steel (SUS and the like). The thickness of the metal substrate 20 is set as appropriate depending on the intended use of the opto-electric hybrid board, but it is preferred that the thickness of the metal substrate 20 is typically 1 to 5 mm. Preferably, the material of the above-mentioned insulation layer 21 used herein includes photosensitive resins such as photosensitive polyimide resins, photosensitive polyamide resins, photosensitive epoxy resins, photosensitive silicone resins, and the like. In general, the insulation layer 21 is formed by making a difference in solubility between an exposed portion and an unexposed portion of a photosensitive resin by lower-layer post-exposure bake (PEB) after exposure to light using a photomask, developing this photosensitive resin to remove the unexposed portion, and then performing post-bake by heating. Preferably, the thickness of the above-mentioned insulation layer 21 is 5 to 15 µm.

Next, a seed layer 22 for the formation of metal plating is formed over the entire first surface of the metal substrate 20 on which the above-mentioned insulation layer 21 is formed, for example, by using a thin metal film formation apparatus such as a sputtering apparatus, as shown in Fig. 2 (a) and Fig. 2(b) which is a sectional view of Fig. 2(a). The material of the above-mentioned seed layer 22 used herein is an appropriate material depending on plating metal for use in a metal plating step to be described later. For example, when the plating metal is Cu, Cu/NiCr is preferably used for the seed layer 22. Preferably, the thickness of the above-mentioned seed layer 22 is 5 to 20 µm, particularly 10 to 12 µm.

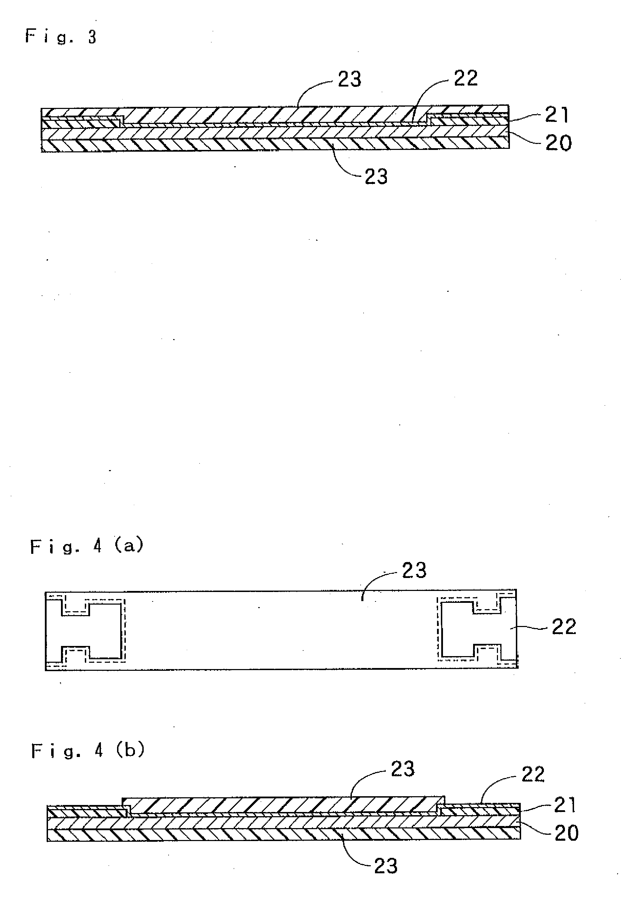

Next, a dry film resist (DFR) 23 is laminated to opposite surfaces of the metal substrate 20 formed with the insulation layer 21 and the seed layer 22 described above, as shown in Fig. 3. Thereafter, the first surface of the metal substrate 20 on which the insulation layer 21 and the seed layer 22 described above are formed is exposed to light by using a photomask, and is then developed. This removes regions of the dry film resist 23 which overlie the above-mentioned insulation layer 21 to expose the seed layer 22 in these regions, as shown in Fig. 4(a) and Fig. 4(b) which is a sectional view of Fig. 4(a).

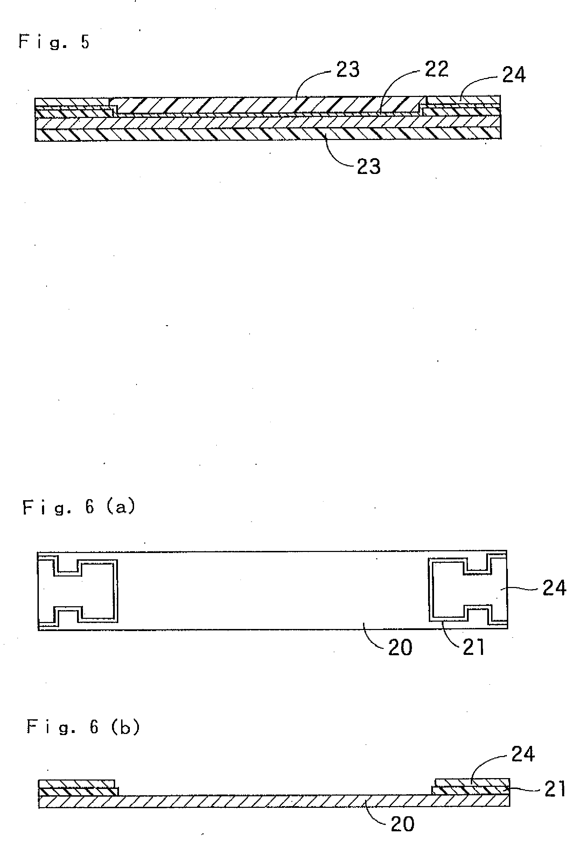

Then, for example, metal plating (an additive process) is performed on these regions to form a conductor preparation layer 24 in the regions in which the seed layer 22 is exposed, as shown in Fig. 5. Examples of the metal used for the above-mentioned metal plating include Cu, Ni, Pb, Ag and the like. Particularly, Cu is preferable. Preferably, the thickness of the above-mentioned conductor preparation layer 24 is 5 to 20 µm, particularly 10 to 12 µm.

Next, the dry film resist 23 on the opposite surfaces of the metal substrate 20 is stripped away by using an alkali aqueous solution. Then, an unnecessary portion of the seed layer 22 except where the conductor preparation layer 24 is formed is removed by etching using an etchant such as an aqueous solution of ferrous chloride and the like. This provides the conductor preparation layer 24 (including the underlying seed layer) on the first surface of the metal substrate 20, with the insulation layer 21 therebetween, as shown in Fig. 6 (a) and Fig. 6(b) which is a sectional view of Fig. 6(a).

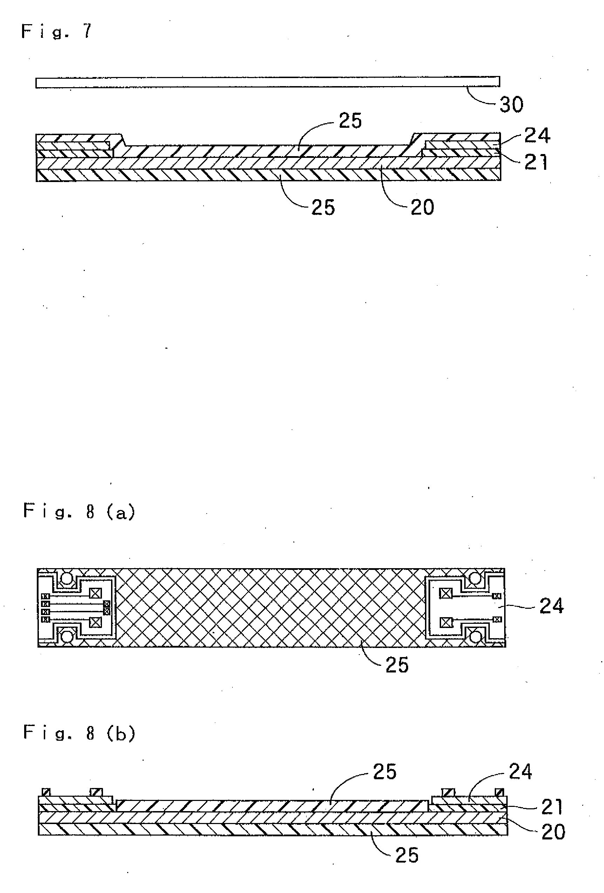

Then, as shown in Fig. 7, a dry film resist 25 is laminated to the opposite surfaces of the above-mentioned metal substrate 20. Thereafter, the first surface of the metal substrate 20 on which the insulation layer 21 and the conductor preparation layer 24 described above are formed is exposed to light by using a photomask 30 positioned in place. This transfers a transfer pattern (not shown) provided in the form of an opening in the photomask 30 onto the dry film resist 25. The above-mentioned transfer pattern includes at least a pattern indicating a pad position for placing a light-emitting element and a light-receiving element thereon, a wiring pattern for electrically connecting the placed light-emitting and light-receiving elements, and an alignment opening pattern for use in alignment with the optical wiringboard. Thus, the above-mentioned transfer pattern is transferred from the single photomask directly onto the dry film resist 25 side by the exposure to light, and is then developed. This accomplishes the positioning of three components, i.e. pads, interconnect lines and alignment openings, with high accuracy.

Then, an unnecessary portion of the dry film resist 25 other than the transferred portion is dissolved away. This provides a structure such that only a predetermined portion (a cross-hatched portion) is covered with the dry film resist 25 but the conductor preparation layer 24 and the metal substrate 20 are partially exposed, as shown in Fig. 8(a) and Fig. 8(b) which is a sectional view of Fig. 8(a).

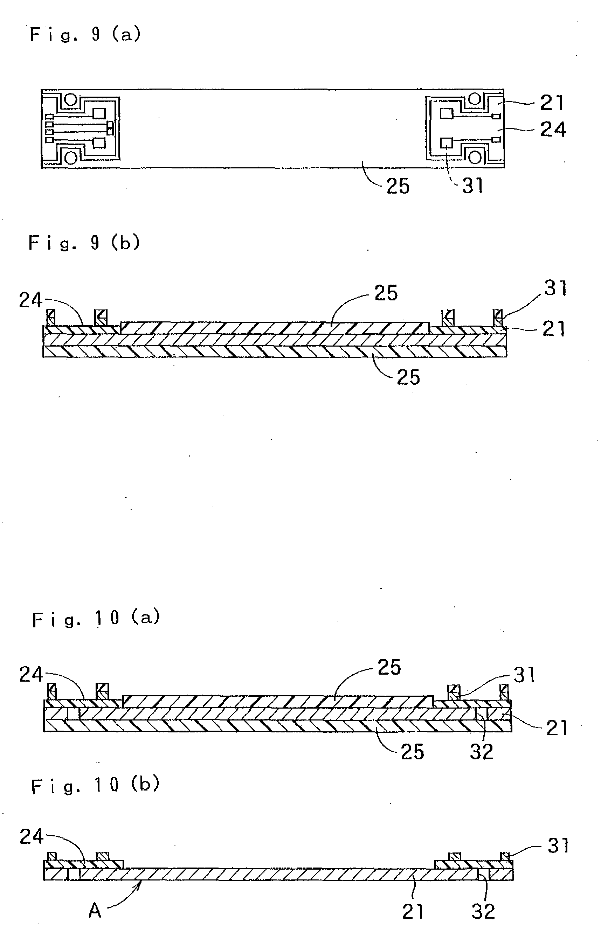

Then, an unnecessary portion of the conductor preparation layer 24 to which the pattern indicating the pad position and the wiring pattern are transferred is removed, for example, by etching (a subtractive process). This forms a conductor layer 31, as shown in Fig. 9(a) and Fig. 9(b) which is a sectional view of Fig. 9(a).

Portions transferred in the form of the alignment opening pattern (portions in which the metal substrate 20 is exposed by the removal of the dry film resist 25) are removed by etching by using an etchant such as ferrous chloride and the like. This forms alignment openings 32, as shown in Fig. 10(a).

After this structure is cleaned, the dry film resist 25 on the opposite sides is stripped away by using an alkali aqueous solution as shown in Fig. 10 (b). Then, the resultant structure is cleaned again to prevent the occurrence of alkalization. Then, a Ni-Au plating process is performed on the pads for placing the light-emitting and light-receiving elements thereon. This provides an electrical wiring board A.

### (2) Production of Optical Wiring Board

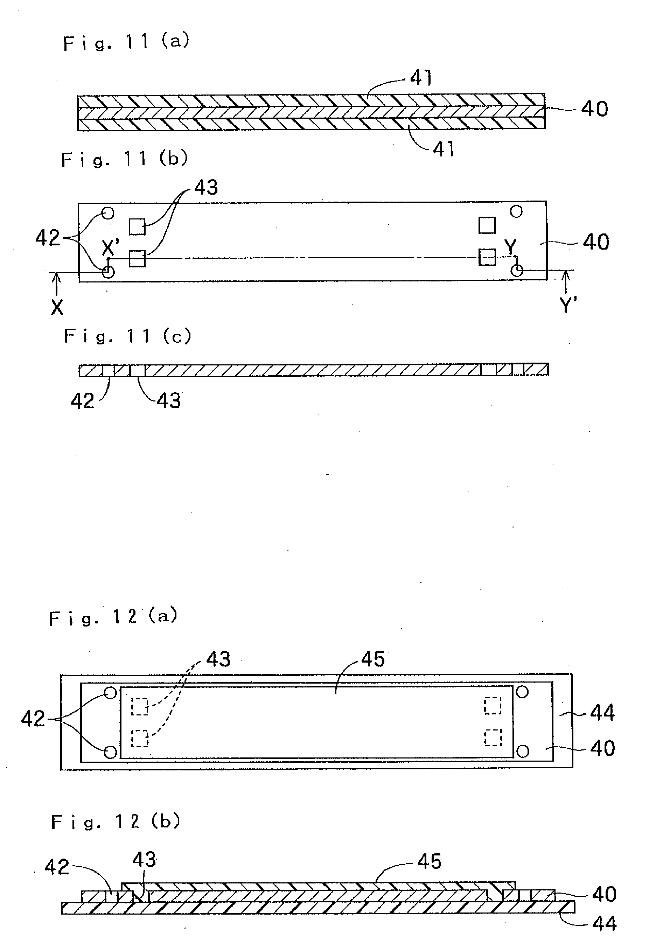

On the other hand, a metal substrate 40 is prepared, and opposite surfaces of the metal substrate 40 are covered with a dry film resist 41, as shown in Fig. 11(a). Using a photomask formed with an opening pattern indicating the arrangement of alignment openings and optical coupling openings, photolithography is done to transfer the above-mentioned pattern onto the dry film resist 41 and to develop the dry film resist 41. This exposes the surface of the metal substrate 40 in portions where the alignment openings and the optical coupling openings are to be formed. The exposedportions of the metal substrate 40 are etched, and the dry film resist 41 is stripped away. This provides the metal substrate 40 formed with alignment openings 42 and optical coupling openings 43 on the right-hand and left-hand sides, as shown in Fig. 11 (b) and Fig. 11 (c) which is a sectional view taken along the lines X-X'-Y'-Y of Fig. 11(b). The opening pattern indicating the arrangement of the alignment openings 42 and the optical coupling openings 43 described above is transferred from the single photomask directly onto the dry film resist 41 side by the exposure to light, and is then developed. This accomplishes the positioning of the alignment openings 42 and the optical coupling openings 43 with high accuracy.

Next, a polyester self-adhesive film 44 is laminated to the back surface of the above-mentioned metal substrate 40, and an under cladding layer 45 is formed on the front surface of the metal substrate 40, as shown in Fig. 12(a) and Fig. 12(b) which is a sectional view of Fig. 12(a). A region in which the above-mentioned under cladding layer 45 is formed overlies the optical coupling openings 43 but does not overlap the alignment openings 42.

A varnish prepared by dissolving a general cladding formation material such as, for example, a photosensitive resin, a polyimide resin, an epoxy resin and the like in a solvent is used for the above-mentioned under cladding layer 45. The thickness of the under cladding layer 45 is not particularly limited. The use of photolithography as a method of forming the under cladding layer 45 is advantageous in forming the under cladding layer 45 in a limited specific region.

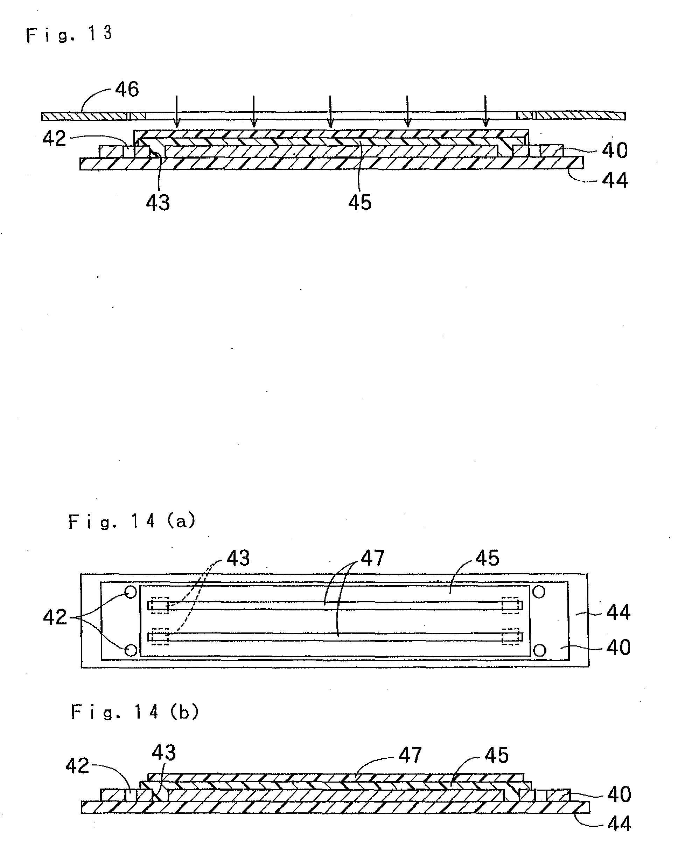

Next, as shown in Fig. 13, a core formation material is applied onto the upper surface of the above-mentioned under cladding layer 45. The core formation material is exposed to light by using a photomask 46 positioned over the core formation material, and is then developed. This forms two linear core layers 47, as shown in Fig. 14(a) and Fig. 14(b) which is a sectional view of Fig. 14(a). In this process, alignment with alignment marks on the photomask 46 side is done by using the above-mentioned alignment openings 42 as alignment marks. This accomplishes the positioning of the core layers 47 relative to the optical coupling openings 43 with high accuracy.

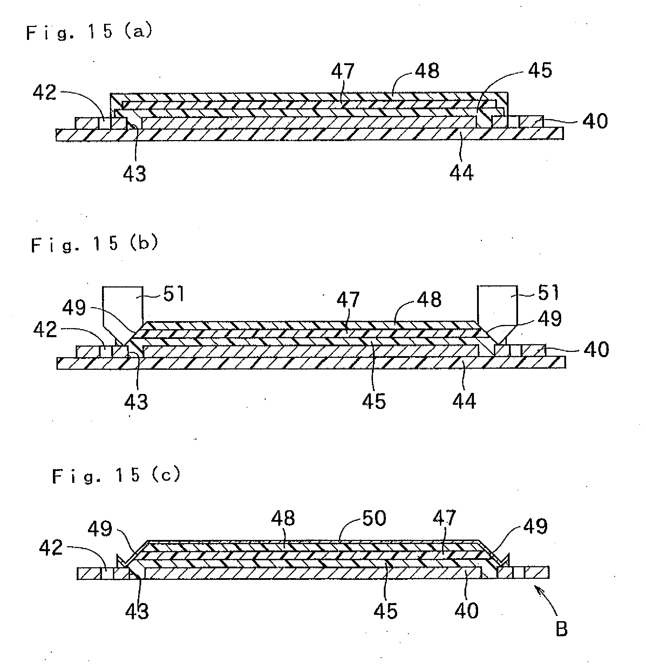

The above-mentioned core layers 47 may be formed by using a varnish prepared by dissolving a general core formationmaterial such as, for example, a photosensitive resin, a polyimide resin, an epoxy resin and the like in a solvent. The thickness of the core layers 47 is not particularly limited. The above-mentioned core layers 47, however, is required to have a refractive index greater than that of the above-mentioned under cladding layer 45 and that of an over cladding layer 48 to be described later with reference to Fig. 15(a). The adjustment of the above-mentioned refractive index may be made, for example, by adjusting the selection of the types of the materials for the formation of the above-mentioned under cladding layer 45, the core layers 47 and the over cladding layer 48 and the compositions thereof.

Next, the over cladding layer 48 covering the above-mentioned core layers 47 is formed, as shown in Fig. 15(a). A varnish prepared by dissolving a general cladding formation material such as, for example, a photosensitive resin, a polyimide resin, an epoxy resin and the like in a solvent is used for the above-mentioned over cladding layer 48. The thickness of the over cladding layer 48 is not particularly limited. The use of photolithography as a method of forming the over cladding layer 48 is advantageous in forming the over cladding layer 48 in a limited specific region. Of course, a quartz die or the like may be used for the cast molding of the cladding formation material.

Next, as shown in Fig. 15(b), a dicing process using dicing blades 51 is performed to form 45-degree mirrors 49 over the optical coupling openings 43. Thereafter, as shown in Fig. 15(c), a sputtering process or the like is performed on surfaces where the above-mentioned 45-degree mirrors 49 are formed to form a metallized film 50 thereon, and the polyester self-adhesive film 44 is stripped away from the back surface of the metal substrate 40. This provides an optical wiring board B in which an optical waveguide including the under cladding layer 45, the core layers 47 and the over cladding layer 48 is laminated onto the metal substrate 40.

### (3) Alignment and Fixing of Two Boards

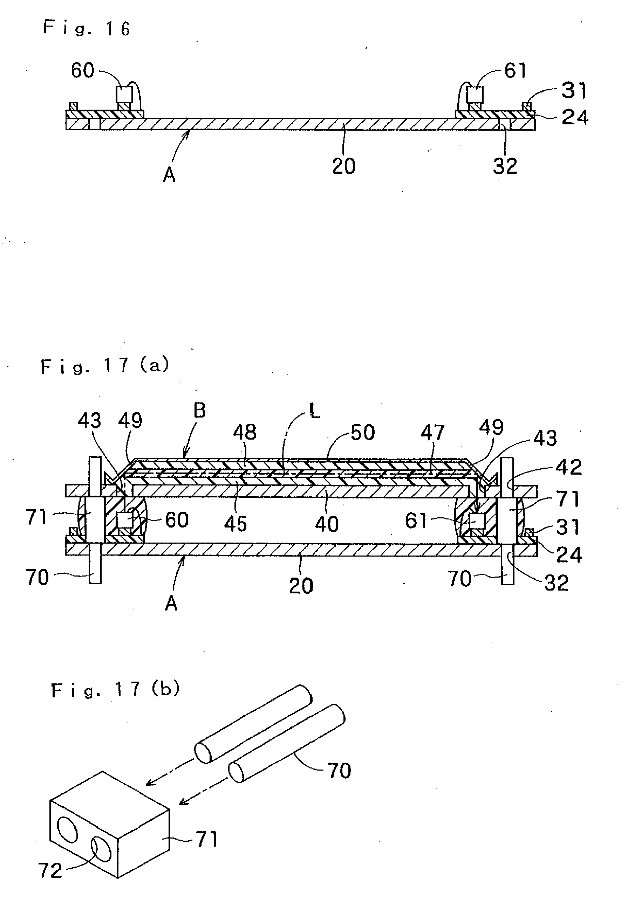

First, in the electrical wiring board A formed with the above-mentioned conductor layer 31 and the alignment openings 32, a light-emitting element (VCSEL) 60 is mounted on the left-hand pad as seen in the drawing and a light-receiving element (PD) 61 is mounted on the right-hand pad as seen in the drawing, as shown in Fig. 16.

Then, as shown in Fig. 17 (a), the electrical wiring board A with the above-mentioned light-receiving and light-emitting elements 61 and 60 mounted thereon and the optical wiring board B with the above-mentioned optical waveguide laminated thereto are placed in parallel, vertically opposed relation. Then, alignment between the two boards A and B is performed by using guide pins 70 and spacers 71 provided with through holes 72 for receiving the guide pins 70, which are shown in Fig. 17(b).

For the alignment using the above-mentioned guide pins 70, the spacers 71 are placed between the electrical wiring board A and the optical wiring board B. Then, the guide pins 70 are fitted into the alignment openings 32 of the electrical wiring board A, the through holes 72 of the spacers 71, and the alignment openings 42 of the optical wiring board B which are arranged in coaxial relation, as shown in Figs. 17(a) and 17(b). This accomplishes the alignment of the two boards A and B.

The presence of the above-mentioned spacers 71 between the two boards A and B forms a predetermined gap therebetween. This is done in consideration for prevention against damages to bonding wires of the light-receiving and light-emitting elements 61 and 60 between the two boards A and B. The formation of the above-mentioned gap allows the dissipation of heat generated around the boards A and B through the gap. This also produces the additional effect of ensuring the high performance of the opto-electric hybrid board over a long period of time.

The fitted portions between the above-mentioned guide pins 70 and the alignment openings 32 and 42 are fixed by using an adhesive such as an ultraviolet curable adhesive, resin, and the like. This provide an intended opto-electric hybrid board.

The opto-electric hybrid board thus obtained is capable of forming an optical path as indicated by dash-and-dot lines L in Fig. 17(a). Since the interconnect lines of the electrical wiring board A and the optical wiring board B and the like are correctly disposed relative to the alignment openings of the two boards A and B, the light-receiving and light-emitting points of the light-receiving and light-emitting elements 61 and 60 mounted on the electrical wiring board A, and the light-receiving and light-emitting points of the optical waveguide of the optical wiring board B are aligned with each other with high accuracy. This allows the transmission of light with high efficiency. Thus, this opto-electric hybrid board is widely used as a board for electric and electronic components using various optical communications, optical information processing and optics, such as an O/E connect (for example, a hinge for a cellular mobile phone and the like), a touch panel, and the like.

According to the present invention, it is essential for the production of the electrical wiring board A to use lithography for the purpose of transferring the conductor and opening pattern indicating the arrangement of the pads for mounting the light-receiving and light-emitting elements 61 and 60 thereon, the interconnect lines and the alignment openings 32. It is also essential for the Production of the optical wiring board B to use lithography for the purpose of transferring the opening pattern indicating the arrangement of the alignment openings 42 and the optical coupling openings 43. However, the other steps may safely use any technique.

For example, the alignment openings 32 and 42 are formed by etching in the above-mentioned instance. However, the formation of the alignment openings 32 and 42 need not necessarily use etching, but may be accomplished by laser beam machining, punching or blanking, and the like.

The two alignment openings 32 are provided in each of the opposite end portions of the metal substrate 20 and the two alignment openings 42 are provided in each of the opposite end portions of the metal substrate 40 in the above-mentioned instance. However, the number of alignment openings 32 and the number of alignment openings 42 may be increased (for example, four) for the purpose of improving accuracy.

The formation of the conductor layer 31 is not limited to the above-mentioned instance, but may use a subtractiveprocess, an additive process, asemi-additive process, and the like, as appropriate.

Further, the method of forming the 45-degree mirrors in the production of the optical wiring board B is not limited to dicing, but may use appropriate methods such as laser beam machining and the like. Of course, there are cases where the above-mentioned 45-degree mirrors need not be formed depending on the configuration of the optical waveguide provided in the optical wiring board B. As an example, the optical waveguide may be replaced with an optical waveguide film disposed by using a predetermined optical connector, and an optical fiber. Additionally, the optical wiring board B may include a specific optical transmission block such that an optical waveguide is formed within a rigid resin member.

When the alignment between the electrical wiring board A and the optical wiring board B is performed by using the guide pins 70 in the above-mentioned instance, the spacers 71 are placed between the two boards A and B to provide a gap between the two boards A and B. It is not necessary to prepare the spacers 71 having the through holes 72 for receiving the guide pins 70. For example, spacers for gap formation may be previously attached to a surface of one of the electrical wiring board A and the optical wiring board B which is opposed to the other. Depending on the types and the mounting configurations of the light-receiving and light-emitting elements 61 and 60, the electrical wiring board A and the optical wiring board B may be directly fixed and laminated to each other without the gap provided between the two boards A and B. In this case, the spacers 71 are unnecessary.

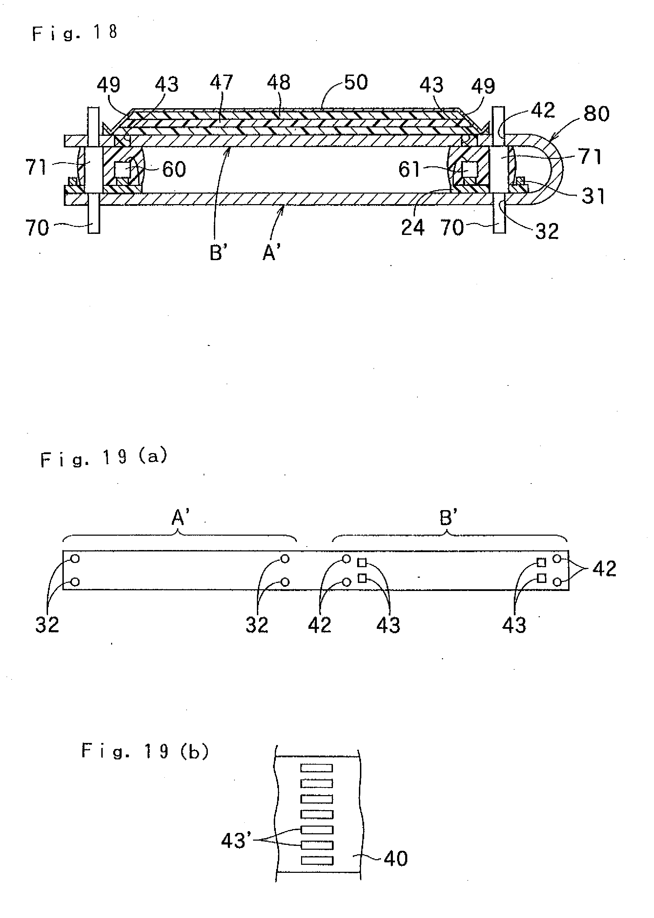

In the above-mentioned instance, the electrical wiring board A and the optical wiring board B are produced from the individual metal substrates 20 and 40, respectively. Alternatively, as shown in Fig. 18. a single strip-shaped metal substrate 80 may be used to produce an electrical wiring board portion A' similar to the electrical wiring board A in the above-mentioned instance in one longitudinal end portion of the strip-shapedmetal substrate 80, and to produce an optical wiring board portion B' similar to the optical wiring board B in the above-mentioned instance in the other longitudinal end portion of the strip-shaped metal substrate 80. The strip-shaped metal substrate 80 is folded back so that the electrical wiring board portion A' and the optical wiring board portion B' are opposed to each other. In this state, the electrical wiring board portion A' and the optical wiring board portion B' are fixed by using the guide pins 70. This provides an excellent opto-electric hybrid board similar to that of the above-mentioned instance. (Like reference numerals and characters are used to designate components of this opto-electric hybrid board similar to those of the above-mentioned instance, and the components of this opto-electric hybrid board will not be further described.)

In this case, it is preferred that the electrical wiring board portion A' and the optical wiring board portion B' described above are not formed on the same surface of the strip-shaped metal substrate 80 but are formed on opposite surfaces thereof because this arrangement allows the electrical wiring board portion A' and the optical wiring board portion B' to be opposed to each other only by folding back the strip-shaped metal substrate 80 at a boundary therebetween into an arcuate shape. Of course, the electrical wiring board portion A' and the optical wiring board portion B' describe above may be formed in juxtaposition on the same surface of the strip-shaped metal substrate 80, and are safely opposed to each other by turning the boundary therebetween 180 degrees and then folding back the strip-shaped metal substrate 80.

For the production of the electrical wiring board portion A' and the optical wiring board portion B' described above, it is preferred that the opening pattern of the alignment openings 32 of the electrical wiring board portion A' and the opening pattern of the alignment openings 42 and the optical coupling openings 43 of the optical wiring board portion B' be simultaneously transferred by using a single photomask to form the openings, as shown in Fig. 19 (a). Thereafter the board portions A' and B' are produced.

In the instance shown in Fig. 18, if conductor interconnect lines of one of the light-receiving and light-emitting elements 61 and 60 which is mounted near the fold (in this case, the light-receiving element 61) are extended toward the fold, it is difficult for the conductor interconnect lines to be coupled to other parts. It is therefore preferred that the conductor interconnect lines in the electrical wiring board portion A' be configured to extend in a transverse direction of the substrate 80 (toward the viewer as seen in Fig. 18).

According to the present invention, when the light-receiving element (PD and the like) 61 mounted on the electrical wiring board A (including the electrical wiring board portion A') is of an array type, it is necessary that optical coupling openings 43' formed in the optical wiring board B (including the strip-shaped metal substrate 80 provided with the optical wiring board portion B') be configured to correspond in number and arrangement with light-receiving portions of the above-mentioned light-receiving element 61.

### EXAMPLES

### Example 1

An opto-electric hybrid board was manufactured in a manner similar to the present invention described above (with reference to Figs. 1 to 17), more specifically in a manner to be described below.

### (1) Production of Electrical Wiring Board

A photosensitive polyimide having a thickness of 10 µm was applied onto an SUS substrate having a thickness of 0.025 mm, a width of 50 mm and a length of 150 mm. Thereafter, a future insulation layer portion was exposed to light by using a photomask. Thus, a difference was made in solubility between an exposed portion and an unexposed portion of the polyimide by lower-layer PEB. Then, the unexposed portion was removed by using a developing solution. Thereafter, polyimide cure was performed by heating, and the cured exposed portion functioned as an insulation layer as shown in Figs. 1(a) and 1(b).

Next, a sputtering apparatus was used to form a Cu/NiCr seed layer (having a Cu thickness of 0.15 µm and a NiCr thickness of 0.15 µm) for Cu plating on a first surface of the above-mentioned SUS substrate on which the insulation layer was formed as shown in Figs. 2(a) and 2(b). Then, a dry film resist (DFR) was laminated to opposite surfaces of the above-mentioned SUS substrate. The dry film resist formed on the first surface of the SUS substrate on which the insulation layer was formed was exposed to light and developed by photolithography. This removed an exposed portion of the dry film resist to expose portions of the seed layer which became pads for mounting light-emitting and light-receiving elements thereon (as shown in Figs. 3, 4(a) and 4(b).

Next, Cu plating (having a thickness of 10 to 12 µm) was formed on the above-mentioned exposed seed layer as shown in Fig. 5. The dry film resist was stripped away. Thereafter, seed etching was performed to remove an unnecessary portion of the seed layer as shown in Figs. 6(a) and 6(b).

Next, a dry film resist was laminated again to the opposite surfaces of the above-mentioned SUS substrate, and photolithography was performed to form a conductor pattern including electrical interconnect lines and the like and an opening pattern for alignment as shown in Figs. 7, 8(a) and 8(b). Cu etching (a subtractive process) was performed to form Cu interconnect lines along the above-mentioned conductor pattern as shown in Figs. 9(a) and 9(b). Thereafter, SUS etching was performed to form alignment openings in the SUS substrate as shown in Figs. 10(a) and 10(b). An alkali aqueous solution was used to strip away the dry film resist from the opposite surfaces. This provided an electrical wiring board with the alignment openings in which a conductor layer was formed on the SUS substrate, with the insulation layer therebetween.

### (2) Production of Optical Wiring Board

A dry film resist was laminated to opposite surfaces of an SUS substrate having a thickness of 0.025 mm, a width of 50 mm and a length of 150 mm as shown in Fig. 11(a). An opening pattern for optical coupling openings and alignment openings was formed by photolithography. SUS etching was performed to form the optical coupling openings and the alignment openings. Thereafter, an alkali aqueous solution was used to strip away the dry film resist from the opposite surfaces as shown in Figs. 11(b) and 11(c).

Next, a polyester self-adhesive film was laminated to the back surface of the above-mentioned SUS substrate, and an under cladding varnish having composition described below and having a thickness of 25 µm was applied to the front surface of the SUS substrate. Thereafter, exposure to light and development were performed by photolithography to form an under cladding layer as shown in Figs. 12(a) and 12(b).

### Composition of Under Cladding Varnish

35 parts by weight of bisphenoxyethanolfluorene diglycidyl ether
40 parts by weight of (3'-4'-epoxycyclohexane) methyl-3'-4'-epoxycyclohexyl-carboxylate
25 parts by weight of an alicyclic epoxy resin (Celloxide 2021P manufactured by Daicel Chemical Industries, Ltd.)
one part by weight of a 50 wt % propione carbonate solution of 4,4'-bis[di(β-hydroxyethoxy)phenylsulfinio]phenylsulfide-bis-hexafluoroantimonate (a photo-acid generator)

Next, a core varnish having composition described below and having a thickness of 50 µm was applied onto the above-mentioned under cladding layer. Thereafter, exposure to light and development were performed by photolithography to form core layers as shown in Figs. 13, 14(a) and 14(b).

### Composition of Core Varnish

70 parts by weight of bisphenoxyethanolfluorene diglycidyl ether
30 parts by weight of 1,3,3-tris{4-[2-(3-oxetanyl)]butoxyphenyl}butane
0.5 part by weight of a 50 wt % propione carbonate solution of 4,4'-bis[di(β-hydroxyethoxy)phenylsulfinio]phenylsulfide-bis-hexafluoroantimonate (a photo-acid generator)
28 parts by weight of ethyl lactate

Next, an over cladding varnish having composition similar to that of the above-mentioned under cladding varnish and having a thickness of 25 µm was applied onto the above-mentioned core layers. Thereafter, exposure to light and development were performed by photolithography to form an over cladding layer as shown in Fig. 15(a).

Then, 45-degree mirrors were formed by dicing on portions of an optical waveguide (having a total thickness of 100 µm) including the under cladding layer, the core layers and the over cladding layer described above which lie over the optical coupling openings as shown in Fig. 15(b). Then, a sputtering process was performed to form a metallized film (metal: Ag) on the upper surface of the 45-degree mirrors as shown in Fig. 15(c). In this manner, an optical wiring board including the optical waveguide capable of changing the optical path by 90 degrees was provided.

### (3) Alignment and Fixing of Two Boards

A light-emitting element (VCSEL having a wavelength of 850 nm and manufactured by U-L-M photonics GmbH) was mounted on one of the two pads provided on the left-hand and right-hand sides of the above-mentioned electrical wiring board, and a light-receiving element (a GaAs photodiode manufactured by Albis Optoelectronics AG) was mounted on the other pad as shown in Fig. 16. Two guide pins and a spacer were used to fit first and second ends of the above-mentioned guide pins into the alignment openings of the electrical wiring board and the alignment openings of the optical wiring board, respectively, thereby performing alignment between the two boards. Thereafter, the fitted portions were fixed by using an ultraviolet curable resin as shown in Figs. 17(a) and 17(b). In this manner, an intended opto-electric hybrid board was provided.

It was found that, in the above-mentioned opto-electric hybrid board, the light-emitting element and optical waveguide optically coupled to each other and the optical waveguide and light-receiving element optically coupled to each other had respective optical axes coupled to each other with accumulated tolerances of approximately ±10 µm to accomplish fully passive alignment with an optical loss of not greater than 1 dB.

### Example 2

A strip-shaped SUS substrate having a thickness of 0.025 mm, a width of 50 mm and a length of 300 mm was prepared. One end portion of the strip-shaped SUS substrate was adapted for use as an electrical wiring board portion, and the other end portion thereof was adapted for use as an optical wiring board portion. Alignment openings in a portion for use as the electrical wiring board portion and in a portion for use as the optical wiring board portion, and optical coupling openings in the portion for use as the optical wiring board portion were produced at the same time by photolithography and SUS etching as shown in Fig. 19(a). Except for this, Example 2 was similar to Example 1 described above to produce the components of the electrical wiring board portion and the components of the optical wiring board portion. The electrical wiring board portion and optical wiring board portion described above were produced so that the surfaces of the respective portions were on opposite sides of the strip-shaped SUS substrate.

Then, the above-mentioned strip-shaped SUS substrate was folded back in the middle thereof. With the optical wiring board portion disposed in parallel over the electrical wiring board portion, the guide pins were fitted in the upper and lower alignment openings, and the fitted portions were fixed by using an ultraviolet curable resin in a manner similar to Example 1 described above. Thus, an intended opto-electric hybrid board was provided.

It was found that, in the above-mentioned opto-electric hybrid board, the light-emitting element and optical waveguide optically coupled to each other and the optical waveguide and light-receiving element optically coupled to each other had respective optical axes coupled to each other with accumulated tolerances of approximately ±10 µm to accomplish fully passive alignment with an optical loss of not greater than 1 dB.

Although a specific form of embodiment of the instant invention has been described above and illustrated in the accompanying drawings in order to be more clearly understood, the above description is made by way of example and not as a limitation to the scope of the instant invention. It is contemplated that various modifications apparent to one of ordinary skill in the art could be made without departing from the scope of the invention which is to be determined by the following claims.

## Claims

1. A method of manufacturing an opto-electric hybrid board, comprising the steps of:
(a) producing an electrical wiringboard, said step (a) including the steps of
simultaneously transferring a conductor and opening pattern onto a first metal substrate for electrical wiring by photolithography, the conductor and opening pattern being indicative of the arrangement of pads for mounting light-emitting and light-receiving elements thereon, interconnect lines and alignment openings, and
forming a conductor layer having the pads for mounting the light-emitting and light-receiving elements thereon and the interconnect lines on the first metal substrate, and forming the alignment openings in the first metal substrate, based on the conductor and opening pattern;
(b) producing an optical wiring board, said step (b) including the steps of
simultaneously transferring an opening pattern onto a second metal substrate for optical wiring by photolithography, the opening pattern being indicative of the arrangement of optical coupling openings and alignment openings,
forming the optical coupling openings and the alignment openings in the second metal substrate, based on the opening pattern, and
forming an optical waveguide on the second metal substrate by using the alignment openings as alignment marks;
(c) performing alignment between the electrical wiring board and the optical wiring board, said step (c) including the steps of
preparing guide pins for alignment each having a first end and a second end, and
fitting the first ends of the respective guide pins into the alignment openings of the electrical wiring board and fitting the second ends of the respective guide pins into the alignment openings of the optical wiring board; and
(d) fixing fitted portions between the guide pins and the alignment openings together in this state.

2. A method of manufacturing an opto-electric hybrid board, comprising the steps of:
(a) providing a strip-shaped metal substrate, said step (a) including the steps of
preparing the strip-shapedmetal substrate having a first longitudinal end portion for use as a first metal substrate for electrical wiring and a second longitudinal end portion for use as a second metal substrate for optical wiring,
transferring an opening pattern of alignment openings onto a first region of the strip-shaped metal substrate for use as the first metal substrate and a second region thereof for use as the second metal substrate by photolithography, the alignment openings being used for alignment, with the first and second regions opposed to each other by folding back the strip-shaped metal substrate, and
forming the alignment openings in the first and second regions, based on the opening pattern;
(b) producing an electrical wiring board portion, said step (b) including the steps of
transferring a conductor pattern onto the first region of the strip-shaped metal substrate by photolithography by using the alignment openings as alignment marks, the conductor pattern being indicative of pads for mounting light-emitting and light-receiving elements thereon and interconnect lines, and
forming a conductor layer having the pads for mounting the light-emitting and light-receiving elements thereon and the interconnect lines in the first region, based on the conductor pattern;
(c) producing an optical wiring board portion, said step (c) including the step of
forming an optical waveguide in the second region of the strip-shaped metal substrate by using the alignment openings as alignment marks;
(d) performing alignment between the electrical wiring board portion and the optical wiring board portion, said step (d) including the steps of
preparing guide pins for alignment each having a first end and a second end, and
fitting the first ends of the respective guide pins into the alignment openings of the electrical wiring board portion and fitting the second ends of the respective guide pins into the alignment openings of the optical wiring board portion, with the electrical wiring board portion and the optical wiring board portion opposed to each other by folding back the strip-shaped metal substrate; and
(e) fixing fitted portions between the guide pins and the alignment openings together in this state.

3. An opto-electric hybrid board, comprising:
an electrical wiring board including
a first metal substrate,
a conductor layer formed on the first metal substrate and having pads for mounting light-emitting and light-receiving elements thereon and interconnect lines, and
alignment openings formed in the first metal substrate;
an optical wiring board including
a second metal substrate,
an optical waveguide formed on the second metal substrate,
optical coupling openings for the optical waveguide formed in the second metal substrate, and
alignment openings formed in the second metal substrate; and
guide pins for alignment,
the guide pins having respective first ends fitted in the alignment openings of the electrical wiring board and respective second ends fitted in the alignment openings of the optical wiring board to accomplish alignment between the electrical wiring board and the optical wiring board,
wherein fitted portions between the alignment openings and the guide pins for alignment are fixed together in this state.

4. An opto-electric hybrid board, comprising:
a strip-shaped metal substrate having a first longitudinal end portion provided with an electrical wiring boardportion and a second longitudinal endportion provided with an optical wiring board portion,
the electrical wiring board portion including
a conductor layer formed in a first region of the strip-shaped metal substrate for use as a first metal substrate and having pads for mounting light-emitting and light-receiving elements thereon and interconnect lines, and
alignment openings formed in the first region of the strip-shaped metal substrate,
the optical wiring board portion including
an optical waveguide formed in a second region of the strip-shaped metal substrate for use as a second metal substrate,
optical coupling openings for the optical waveguide formed in the second region of the strip-shaped metal substrate, and
alignment openings formed in the second region of the strip-shaped metal substrate; and
guide pins for alignment,
the guide pins having respective first ends fitted in the alignment openings of the electrical wiring board portion and respective second ends fitted in the alignment openings of the optical wiring board portion, with the strip-shaped metal substrate folded back so that the electrical wiring board portion and the optical wiring board portion are opposed to each other, to accomplish alignment between the electrical wiring board portion and the optical wiring board portion,
wherein fitted portions between the guide pins and the alignment openings are fixed together in this state.
